# EUROPEAN PATENT APPLICATION

(11) **EP 4 059 700 A1**
(43) Date of publication of application: **21.09.2022**
(21) Application number: 20888497.3
(22) Date of filing: 30.10.2020
(51) Int. Cl.: B29C 69/02

(54) **METHOD FOR PRODUCING RESIN JOINED BODY AND APPARATUS FOR PRODUCING RESIN JOINED BODY**

(30) Priority: 15.11.2019 JP 2019206894
(71) Applicant: Toray Industries, Inc., Tokyo, 103-8666 (JP)
(72) Inventor: KANASUGI, Kazuya, Shiga 520-8558 (JP); TONAI, Shunpei, Shiga 520-8558 (JP); YAMASHITA, Yusuke, Shiga 520-8558 (JP)
(74) Representative: Hoefer & Partner Patentanwälte mbB
(86) International application number: PCT/JP2020/040932
(87) International publication number: WO 2021/095578

(57) **Abstract**

Provided are a method and a device for producing an adhesive-free resin bonded body having a high bonding force to a thermoforming member. The present invention is the method for producing a resin bonded body including a first resin member and a second resin member that are bonded to each other. The method includes: a thermoforming step of thermoforming a bonding surface of the first resin member to be bonded to the second resin member and/or a bonding surface of the second resin member to be bonded to the first resin member with the bonding surface covered with inert gas or placed in a vacuum environment; a surface treatment step of activating the bonding surface of the first resin member and/or the second resin member; and a bonding step of attaching the first resin member and the second resin member to each other through the bonding surface of each of the first resin member and the second resin member after the thermoforming step and the surface treatment step.

## Description

### Field

The present invention relates to a method for producing a resin bonded body including a thermoforming step and a device for producing a resin bonded body. Background

A technique for bonding various substrates without an adhesive (hereinafter referred to as adhesive-free bonding) for further miniaturization of semiconductor devices, improvement in optical characteristics of optical devices, and the like has been investigated. In particular, in adhesive-free bonding of resins to be bonded, a lamination technique in which resin bonding surfaces are brought into contact with each other and then heated to the melting temperatures of the resins, resulting in welding, is widely used. However, this technique has a problem in that the degree of crystallization, the molecular structure, and the like of a whole resin member are changed (thermally modified) during heating, to adversely affect optical characteristics and mechanical strength.

Therefore, as a method for bonding a resin to obtain a strong bonding force without imparting heat damage, a method in which bonding surfaces to be bonded of two resin members are surface-treated with an ionizing substance, an electromagnetic wave, or the like, then attached to each other, and pressurized at a low temperature has been investigated. In this adhesive-free bonding, any concavo-convex shape is formed on the resin bonding surface in advance before bonding, and thus, a hollow structure can be formed inside a resin bonded body with the concavo-convex shape maintained. Therefore, the adhesive-free bonding is applicable to microfluidic devices, optical devices, and the like.

Patent Literature 1 discloses a method in which a concave is formed on at least one of a bonding surface of a first resin member and a bonding surface of a second resin member for a flow channel-forming member of a biosensor, a fuel cell, or the like, and the resin bonding surfaces are surface-treated with an ionizing substance, an electromagnetic wave, or the like, and then pressurized at lower than 50°C with a solvent interposed between the bonding surfaces of the resin members.

On the other hand, for three-dimensional formation of a resin member, formation of a fine shape on a surface of the resin member, enhancement in surface smoothness, or the like, various molding procedures such as thermal press working and cutting working are applied. In particular, a thermoforming technique in which a resin that is softened under heating is pressed into a die and molded is widely used since any shape can easily be achieved with precision by using a die according to a purpose.

Non Patent Literature 1 discloses that a surface of a resin member is heated and then pressurized to transfer a fine structure of a die surface to a resin surface by a heat imprint method that is one of the thermoforming techniques.

### Citation List

### Patent Literature

Patent Literature 1: Japanese Patent Application Laid-open No. 2007-245654

### Non Patent Literature

Non Patent Literature 1: Journal of the Japan Society for Precision Engineering, Vol. 76, No. 2, pp. 156 - 160, 2010

### Summary

### Technical Problem

However, the resin member thermoformed by the method described in Non Patent Literature 1 has a problem in that the surface of the resin member is thermally degraded during thermoforming, and the resin member bonded by the method disclosed in Patent Literature 1 does not have a sufficient bonding force-improving effect.

The present invention has been made in view of the above problems, and provides a method and a device for producing an adhesive-free resin bonded body having a high bonding force to a thermoforming resin member. Further, the present invention provides a method and a device for producing a resin bonded body having good optical characteristics when a resin to be bonded is a transparent body.

### Solution to Problem

A method for producing a resin bonded body according to the present invention to solve the above problems is a method for producing a resin bonded body including a first resin member and a second resin member that are bonded to each other. The method includes: a thermoforming step of thermoforming a bonding surface of the first resin member to be bonded to the second resin member and/or a bonding surface of the second resin member to be bonded to the first resin member with the bonding surface covered with inert gas or placed in a vacuum environment; a surface treatment step of activating the bonding surface of the first resin member and/or the bonding surface of the second resin member; and a bonding step of attaching the first resin member and the second resin member to each other through the bonding surface of each of the first resin member and the second resin member after the thermoforming step and the surface treatment step.

A device for producing a resin bonded body according to the present invention to solve the above problems is a device for producing a resin bonded body including a first resin member and a second resin member that are bonded to each other, used in production of the resin bonded body, the device including: a thermoforming system; a surface treatment system; and a bonding system. The thermoforming system includes a gas supply unit configured to supply inert gas to a bonding surface of the first resin member to be bonded to the second resin member and/or a bonding surface of the second resin member to be bonded to the first resin member such that the bonding surface of the first resin member and/or the bonding surface of the second resin member is covered with the inert gas, and a molding unit configured to mold the bonding surface of the first resin member and/or the second resin member that is covered with the inert gas under heating, the surface treatment system is configured to activate the bonding surface of the first resin member and/or the bonding surface of the second resin member, and the bonding system is configured to attach the first resin member and the second resin member to each other through the bonding surface of each of the first resin member and the second resin member.

Another device for producing a resin bonded body according to the present invention to solve the above problems is a device for producing a resin bonded body including a first resin member and a second resin member that are bonded to each other, used in production of the resin bonded body, the device including: a thermoforming system; a surface treatment system; and a bonding system. The thermoforming system includes a partition provided so as to surround a bonding surface of the first resin member to be bonded to the second resin member and/or a bonding surface of the second resin member to be bonded to the first resin member, a gas supply unit configured to supply inert gas into the partition or an exhausting unit configured to exhaust air in inside of the partition resulting in a vacuum state, and a molding unit that is provided inside the partition, the molding unit being configured to mold the bonding surface of the first resin member and/or the second resin member under heating, the surface treatment system is configured to active the bonding surface of the first resin member and/or the second resin member, and the bonding system is configured to attach the first resin member and the second resin member to each other through the bonding surface of each of the first resin member and the second resin member. Advantageous Effects of Invention

The present invention provides a method and a device for producing an adhesive-free resin bonded body having a high bonding force even when a resin member is thermoformed. Further, the present invention provides a method and a device for producing an adhesive-free resin bonded body having good optical characteristics when a resin to be bonded is a transparent body.

### Brief Description of Drawings

FIG. 1 is a schematic view illustrating a first embodiment of a method for producing a resin bonded body of the present invention.
FIG. 2 is a schematic view illustrating a second embodiment of the method for producing a resin bonded body of the present invention.
FIG. 3 is a schematic view illustrating a third embodiment of the method for producing a resin bonded body of the present invention.
FIG. 4 is a schematic view illustrating a fourth embodiment of the method for producing a resin bonded body of the present invention.
FIG. 5 is a schematic view illustrating a fifth embodiment of the method for producing a resin bonded body of the present invention.
FIG. 6 is a schematic view illustrating a sixth embodiment of the method for producing a resin bonded body of the present invention.
FIG. 7 is a schematic view illustrating a seventh embodiment of the method for producing a resin bonded body of the present invention.
FIG. 8 is a schematic view illustrating a first embodiment of a device for producing a resin bonded body of the present invention.
FIG. 9 is a schematic view illustrating a second embodiment of the device for producing a resin bonded body of the present invention.
FIG. 10 is a schematic view illustrating a third embodiment of the device for producing a resin bonded body of the present invention.
FIG. 11 is a schematic view illustrating a fourth embodiment of the device for producing a resin bonded body of the present invention.
FIG. 12 is a schematic view illustrating a fifth embodiment of the device for producing a resin bonded body of the present invention.
FIG. 13 is a schematic view illustrating a sixth embodiment of the device for producing a resin bonded body of the present invention.
FIG. 14 is a schematic view illustrating a seventh embodiment of the device for producing a resin bonded body of the present invention.
FIG. 15 is a schematic view illustrating an eighth embodiment of the device for producing a resin bonded body of the present invention.
FIG. 16 is a schematic view illustrating a molding surface that is formed by a heat press machine used in Examples 1 to 6.

### Description of Embodiments

### [First Embodiment of Method for Producing Resin Bonded Body]

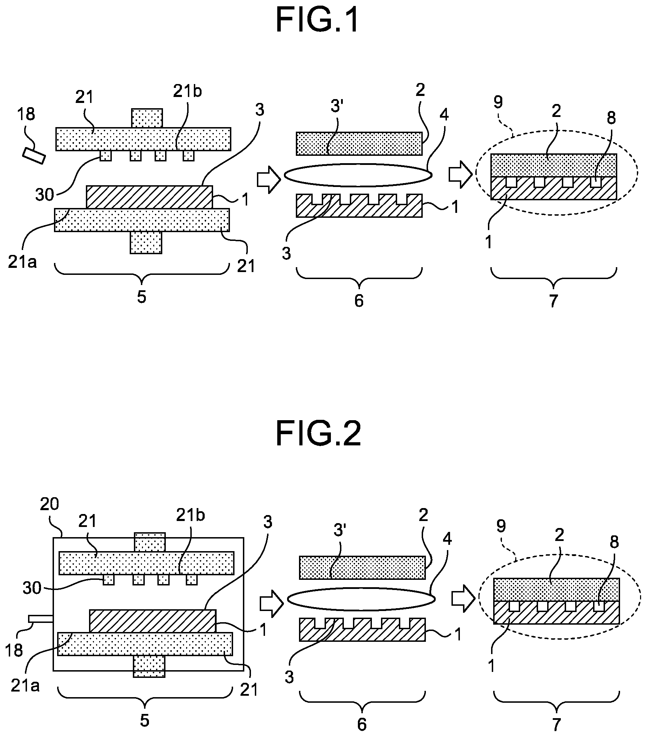

Hereinafter, examples of embodiments of the present invention will be described with reference to the drawings. FIG. 1 is a schematic view illustrating a first embodiment of a method for producing a resin bonded body 9 of the present invention. As illustrated in FIG. 1, the method according to the first embodiment includes a thermoforming step 5 of thermoforming a bonding surface 3 of a first resin member 1 to be bonded to a second resin member 2 and/or a bonding surface 3' of the second resin member 2 to be bonded to the first resin member 1 with the bonding surface 3 and/or 3' covered with inert gas by a molding unit 21; a surface treatment step 6 of activating the bonding surface 3 of the first resin member 1 and/or the bonding surface 3' of the second resin member 2 by a surface treatment unit 4 after the thermoforming step 5; and a bonding step 7 of attaching the first resin member 1 and the second resin member 2 to each other through the bonding surface of each of the first resin member 1 and the second resin member 2 after the surface treatment step 6.

As types of the first resin member 1 and the second resin member 2 used in the present invention, polyethylene (PE), polypropylene (PP), polyamide (PA), polyacetal (POM), polyethylene terephthalate (PET), polybutylene terephthalate (PBT), polyphenylene sulfide (PPS), polyetheretherketone (PEEK), polytetrafluoroethylene (PTFE), polyvinyl chloride (PVC), polystyrene (PS), acrylonitrile butadiene styrene (ABS), polymethyl methacrylate (PMMA), polycarbonate (PC), polyetherimide (PEI), polyamideimide (PAI), or the like can appropriately be selected according to applications. However, it is preferable that a material containing no aromatic moiety in the molecular structure is used. This is because the material containing no aromatic moiety has high thermal mobility of a molecular chain and molecular diffusion (entanglement of the molecular chain) at a bonding interface between the first resin member 1 and the second resin member 2 is increased. As this molecular diffusion is increased, the intermolecular force at the bonding interface is increased, and the bonding force is enhanced. The types of the first resin member 1 and the second resin member 2 may be different from each other. However, it is preferable that the types of the first resin member 1 and the second resin member 2 are the same from the viewpoint of entanglement of the molecular chain at the interface between the bonding surface 3 of the first resin member 1 and the bonding surface 3' of the second resin member 2 during bonding.

### [Thermoforming Step]

The thermoforming step 5 will be described. "Thermoforming" in the present invention refers to molding a resin under heating. At the thermoforming step 5, the bonding surface 3 of the first resin member 1 and/or the bonding surface 3' of the second resin member 2 is thermoformed by the molding unit 21 for formation of any concavo-convex shape, improvement in smoothness, or the like. According to a shape of the resin bonded body 9 to be obtained, only one of the bonding surface 3 and the bonding surface 3' may be thermoformed, or both the bonding surface 3 and the bonding surface 3' may be thermoformed. In the following description of the thermoforming step, a case where the bonding surface 3 of the first resin member 1 is thermoformed will be described, unless specified otherwise. In a case where the bonding surface 3' is thermoformed, the first resin member 1 only needs to be replaced with the second resin member 2, and the bonding surface 3 only needs to be replaced with the bonding surface 3'.

The molding unit 21 at the thermoforming step 5 is not particularly limited, and examples thereof may include heat press molding such as heat imprint working, and laser working.

At the thermoforming step 5, inert gas is supplied to the bonding surface 3 of the first resin member 1 to be thermoformed, by a gas supply unit 18 such as a gas nozzle. Thus, the bonding surface 3 can efficiently be covered with the inert gas. When the bonding surface 3 is covered with the inert gas, a reaction with an oxidizing substance such as oxygen or carbon dioxide can be suppressed, and thermal degradation of the bonding surface 3 during thermoforming can be reduced. "Thermal degradation" in the present invention refers to oxidative deterioration causing a decrease in molecular weight (degradation) at the bonding surface 3, cross-linking, or the like, in cleavage of a molecular chain of a resin caused by oxidation and heat. Due to this thermal degradation, the thermal mobility of the molecular chain that is present at the bonding surface 3 of the first resin member 1 and machine durability are reduced. A change in the molecular structure at the bonding surface 3 due to the thermal degradation can be confirmed by infrared absorption spectroscopy (IR) or the like.

The "inert gas" in the present invention refers to gas that does not cause an oxidation reaction, and examples of types of the inert gas include rare gases such as argon, helium, and neon, and nitrogen gas. Among them, it is preferable that nitrogen gas is used from the viewpoint of cost. The inert gas supplied from the gas supply unit 18 may be a single gas, or a plurality of types of inert gases may be mixed.

An environment filled with the inert gas in the present invention is a state where the oxygen concentration in the air in contact with the bonding surface 3 is less than 20%. As the oxygen concentration is decreased, thermal degradation is reduced, and the bonding force of the resin bonded body 9 is increased. The oxygen concentration at the bonding surface 3 to be thermoformed can be measured with a zirconia oxygen analyzer, a magnetic oxygen analyzer, or the like.

The temperature, pressure, and time during thermoforming can appropriately be set. However, it is preferable that the temperature during thermoforming is set to be equal to or lower than the glass transition temperature (Tg) of a resin constituting the first resin member 1. This is because the whole resin member may be thermally modified at a temperature higher than Tg. It is more preferable that the temperature during thermoforming is set to be equal to or lower than the temperature of deflection under load at which the first resin member 1 can be molded. The temperature of deflection under load depends on Tg of the first resin member 1 and the pressure during thermoforming. The temperature of deflection under load can be decreased with an increase in pressure. Therefore, when the pressure during thermoforming is increased, the bonding surface 3 of the first resin member 1 can be thermoformed at a temperature lower than Tg, and a risk of thermal modification is suppressed.

The temperature of deflection under load can be calculated from a change in elastic modulus relative to the temperature of a sample defined by JIS K7191 (2007).

When in addition to the first resin member 1, the second resin member 2 is thermoformed, the temperature, pressure, and time during thermoforming of the first resin member 1 may be the same as or different from the temperature, pressure, and time during thermoforming of the second resin member 2.

At the thermoforming step 5, the bonding surface 3 that is a thermoformed surface of the first resin member 1 can be made smooth, or a concavo-convex shape can be formed on the bonding surface 3. For example, when the bonding surface 3 of the first resin member 1 placed on an unmolded surface 21a is pressed against a molding surface 21b having a protrusion pattern 30, a rectangular structure having concavo-convex height and width of 100 nm or more, or the like, can be formed on the molding surface 21b. Thus, a fine hollow structure 8 can be formed inside the resin bonded body 9.

### [Surface Treatment Step]

The surface treatment step 6 will be described. At the surface treatment step 6, the bonding surface 3 of the first resin member 1 and/or the bonding surface 3' of the second resin member 2 is surface-treated by the surface treatment unit 4, to activate the bonding surface 3 and/or 3'. Only one of the bonding surface 3 and the bonding surface 3' or both the bonding surface 3 and the bonding surface 3' may be surface-treated. The bonding surface 3 and/or 3' that is thermoformed at the thermoforming step 5 or the bonding surface 3 and/or 3' that is not thermoformed may be surface-treated. In the following description of the surface treatment step, a case where the bonding surface 3 of the first resin member 1 is surface-treated will be described, unless specified otherwise. In a case where the bonding surface 3' is surface-treated, the first resin member 1 only needs to be replaced with the second resin member 2, and the bonding surface 3 only needs to be replaced with the bonding surface 3'.

"Activating" in the present invention means cleaving a molecular chain in a surface layer of the bonding surface 3 by applying energy to the bonding surface 3 of the first resin member 1 and/or imparting a functional group. By cleaving the molecular chain in the surface layer of the bonding surface 3, the thermal mobility of the molecular chain that is present at the bonding surface 3 can be increased (softening temperature can be lowered). By imparting a functional group, a polar functional group such as a hydroxyl group can be produced. The thermal mobility of the molecular chain can be measured with a nano-thermal microscope (Nano TA) or the like. The type and production amount of the polar functional group can be confirmed by infrared absorption spectroscopy (IR) or the like.

The surface treatment unit 4 at the surface treatment step 6 only needs to be a method in which the bonding surface 3 of the first resin member 1 can be activated by applying energy to the bonding surface 3 of the first resin member 1 as described above, and any method can be used.

Only any one of the bonding surface 3 and the bonding surface 3' or both the bonding surface 3 and the bonding surface 3' may be surface-treated. However, when any one of the bonding surface 3 and the bonding surface 3', for example, only the bonding surface 3 is thermoformed, it is preferable that only the bonding surface 3' that is not thermoformed is surface-treated to prevent as much as possible a concavo-convex shape formed during thermoforming from thermally deforming.

Examples of the surface treatment unit 4 for surface treatment include a unit for irradiating the bonding surface 3 of the first resin member 1 with an ionizing substance and a unit for irradiating the bonding surface 3 of the first resin member 1 with an electromagnetic wave. Among the units, any one may be used, or a plurality of the units may be used. For the surface treatment unit 4, it is possible to cleave a molecular chain at a low temperature as compared with a flame treatment such as ITRO treatment. Therefore, even when a concavo-convex shape is formed on the bonding surface 3 during thermoforming, the surface treatment can be performed without thermally deforming the concavo-convex shape. When the strength, time, frequency, and the like of the surface treatment are changed, the amount of a cleaved molecular chain and the amount of an imparted functional group at the bonding surface 3 of the first resin member 1 can easily be controlled.

The "ionizing substance" in the present invention is gas containing a charged particle such as an ion and an electron. Examples of a method for generating the ionizing substance include, but not particularly limited to, a method for applying a voltage (electric field) between metal electrode plates that are spaced apart and that are faced to each other. Examples of the type of gas that produces the ionizing substance include, but not particularly limited to, argon, helium, oxygen, water vapor, and nitrogen. When the gas type, the density of the ionizing substance, and the like are changed, the amount of a cleaved molecular chain and the amount of an imparted functional group at the bonding surface 3 of the first resin member 1 can easily be controlled.

The "electromagnetic wave" in the present invention is a wave formed by a change in electric field and magnetic field of a space. As the wavelength of this wave is decreased, the energy is increased. In particular, when the bonding surface 3 of the first resin member 1 is irradiated with an electromagnetic wave having a wavelength of 200 nm or less, the bonding surface 3 can effectively be activated. When the amount (illuminance), wavelength, and the like of the electromagnetic wave are changed, the type and amount of the functional group produced at the bonding surface 3 of the first resin member 1 can easily be controlled.

### [Bonding Step]

The bonding step 7 will be described. At the bonding step 7, the bonding surface 3 of the first resin member 1 and the bonding surface 3' of the second resin member 2 are faced to each other and attached to each other after the thermoforming step 5 and the surface treatment step 6. By attaching the surfaces, entanglement of a molecular chain at the interface between the bonding surface 3 of the first resin member 1 and the bonding surface 3' of the second resin member 2 (hereinafter referred to as molecular diffusion) and a condensation reaction between polar functional groups (hereinafter referred to as formation of a covalent bond) proceed. Therefore, the bonding force of the resin bonded body 9 can be enhanced, and the resin bonded body 9 having a strong bonding force can be produced. The molecular diffusion and the formation of a covalent bond can be promoted further by reducing thermal degradation of the bonding surface 3 of the first resin member 1 and the bonding surface 3' of the second resin member 2 at the thermoforming step 5 and increasingly activating the bonding surface 3 and/or the bonding surface 3' at the surface treatment step 6.

It is preferable that the first resin member 1 and the second resin member 2 are pressure-bonded by a press or the like so that a space due to waviness of the bonding surface 3 of the first resin member 1 and the bonding surface 3' of the second resin member 2, or the like is not generated at the bonding interface. In this case, the actual contact area between the first resin member 1 and the second resin member 2 is increased, and the bonding force of the resin bonded body 9 is enhanced.

When the temperatures of the first resin member 1 and the second resin member 2 are higher at the bonding step 7, the molecular diffusion and the condensation reaction at the bonding interface of the resin bonded body 9 are promoted. On the other hand, when the temperatures of the first resin member 1 and the second resin member 2 are a temperature higher than Tg of resins constituting the respective resin members, the molecular structures of the resins constituting the respective resin members are changed (thermally modified), and the machine characteristics, optical characteristics, and the like of the first resin member 1 and the second resin member 2 may be deteriorated. Therefore, it is preferable that the temperatures of the whole first resin member 1 and the whole second resin member 2 at the bonding step 7 are set to be equal to or lower than Tg. In this case, a good resin bonded body 9 can be produced without changing the molecular structures of the resins constituting the first resin member 1 and the second resin member 2, and the like. The temperatures of the first resin member 1 and the second resin member 2 at the bonding step 7 may be the same as or different from each other.

A unit for heating the first resin member 1 and the second resin member 2 at the bonding step 7 is not particularly limited, and an infrared radiation heater, a microwave heater, an ultrasonic heater, a heat press machine, a hot air drier, a heating furnace, or the like can be used.

After the resin bonded body 9 is produced at the bonding step 7, the resin bonded body 9 may be post-heated. Thus, the molecular diffusion at the bonding interface is promoted, and the bonding force of the resin bonded body 9 is further enhanced. A post-heating unit is not particularly limited, and an infrared radiation heater, a microwave heater, an ultrasonic heater, a heat press machine, a hot air drier, a heating furnace, or the like can be used. It is preferable that the temperature of post-heating is set to be equal to or lower than the glass transition temperatures (Tg) of the first resin member 1 and the second resin member 2 from the viewpoint of preventing thermal modification.

### [Second Embodiment of Method for Producing Resin Bonded Body]

FIG. 2 is a schematic view illustrating a second embodiment of the method for producing the resin bonded body 9 of the present invention. The thermoforming step is a difference between the method according to the first embodiment and the method according to the second embodiment. In the method according to the first embodiment, inert gas is supplied to the bonding surface 3 of the first resin member 1 to be thermoformed. In the method according to the second embodiment, a partition 20 is provided so as to surround the bonding surface 3 of the first resin member 1 as illustrated in FIG. 2, and inert gas is supplied to the inside of the partition 20 from the gas supply unit 18. When the inert gas is supplied to the inside of the partition 20 as described above, the inside of the partition 20 can be filled with the inert gas. Therefore, a state where the bonding surface 3 of the first resin member 1 is covered with the inert gas can be produced like the method according to the first embodiment.

In FIG. 2, the whole first resin member 1 is surrounded by the partition 20. However, the thermoforming step 5 may be performed with the whole second resin member 2 surrounded by the partition 20. Alternatively, the thermoforming step 5 may be performed with the whole first resin member 1 and the whole second resin member 2 surrounded by the partition 20, or the thermoforming step 5 may be performed with only the bonding surface 3 of the first resin member 1 or the bonding surface 3' of the second resin member 2 surrounded by the partition 20.

### [Third Embodiment of Method for Producing Resin Bonded Body]

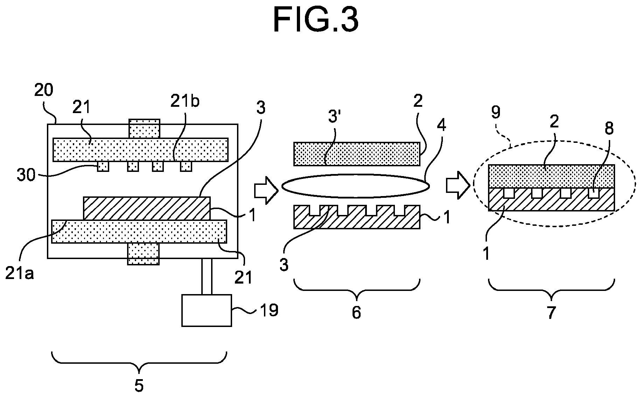

FIG. 3 is a schematic view illustrating a third embodiment of the method for producing the resin bonded body 9 of the present invention. The thermoforming step 5 is a difference between the method according to the first embodiment and the method according to the third embodiment. In the method according to the first embodiment, inert gas is supplied to the bonding surface 3 of the first resin member 1 to be thermoformed. In the method according to the third embodiment, the partition 20 is provided so as to surround the bonding surface 3 of the first resin member 1 as illustrated in FIG. 3, air inside the partition 20 is exhausted by an exhausting unit 19, and the inside of the partition 20 is made in a vacuum state.

In the method according to the first embodiment, when the bonding surface 3 of the first resin member 1 is covered with inert gas, a reaction of the bonding surface 3 of the first resin member 1 with an oxidizing substance such as oxygen or carbon dioxide is suppressed. However, in the method according to the third embodiment, when the inside of the partition 20 is made in a vacuum state, a reaction of the bonding surface 3 of the first resin member 1 with an oxidizing substance such as oxygen or carbon dioxide is suppressed. "Vacuum" in the present invention refers to a gas pressure lower than 1,013 hPa that is an atmospheric pressure. As the gas pressure is decreased, the amount of the oxidizing substance is decreased, and thermal degradation can be reduced.

In FIG. 3, the whole first resin member 1 is surrounded by the partition 20. However, the thermoforming step 5 may be performed with the whole second resin member 2 surrounded by the partition 20. Alternatively, the thermoforming step 5 may be performed with the whole first resin member 1 and the whole second resin member 2 surrounded by the partition 20, or only the bonding surface 3 of the first resin member 1 or the bonding surface 3' of the second resin member 2 may be surrounded by the partition 20.

### [Fourth Embodiment of Method for Producing Resin Bonded Body]

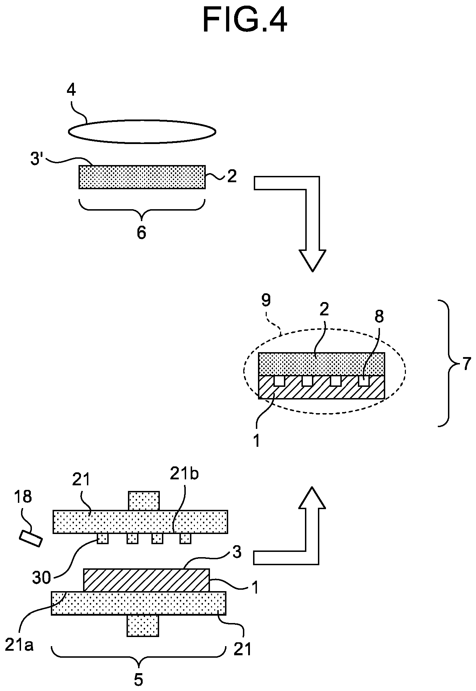

FIG. 4 is a schematic view illustrating a fourth embodiment of the method for producing the resin bonded body 9 of the present invention. In the method according to the fourth embodiment, inert gas is supplied to the bonding surface 3 of the first resin member 1 and the bonding surface is thermoformed with the bonding surface covered with the inert gas at the thermoforming step 5, the bonding surface 3' of the second resin member that is not thermoformed at the thermoforming step 5 is activated at the surface treatment step 6, and the bonding surface 3 of the first resin member 1 is attached to the bonding surface 3' of the second resin member 2 at the bonding step 7 after the thermoforming step 5 and the surface treatment step 6.

In the method according to the first embodiment, the surface treatment step 6 is performed after the thermoforming step 5. However, in the method according to the fourth embodiment, the thermoforming step 5 and the surface treatment step 6 may be performed in any order or in parallel, as illustrated in FIG. 4. This is because the bonding surface 3 to be thermoformed at the thermoforming step 5 is different from the bonding surface 3' to be surface-treated at the surface treatment step 6.

In FIG. 4, the bonding surface 3 of the first resin member 1 is thermoformed, and the bonding surface 3' of the second resin member 2 is surface-treated. However, the bonding surface 3' of the second resin member 2 may be thermoformed, and the bonding surface 3 of the first resin member 1 may be surface-treated.

### [Fifth Embodiment of Method for Producing Resin Bonded Body]

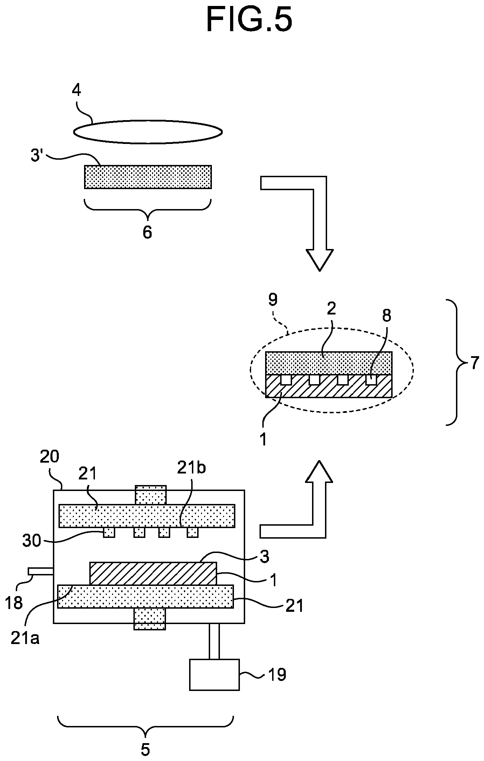

FIG. 5 is a schematic view illustrating a fifth embodiment of the method for producing the resin bonded body 9 of the present invention. The method according to the fifth embodiment is the same as the method according to the fourth embodiment except that the thermoforming step 5 is changed. Specifically, in the method according to the fourth embodiment, inert gas is supplied to the bonding surface 3 of the first resin member 1 to be thermoformed at the thermoforming step 5. In the method according to the fifth embodiment, the bonding surface 3 of the first resin member 1 is surrounded by the partition 20, air inside of the partition 20 is exhausted, and the inside of the partition 20 is made in a vacuum state at the thermoforming step 5, as illustrated in FIG. 5. That is, the same step as the thermoforming step 5 in the method according to the third embodiment is performed.

In the method according to the fifth embodiment, the thermoforming step 5 and the surface treatment step 6 may be performed in any order or in parallel, as illustrated in FIG. 5. This is because the bonding surface 3 to be thermoformed at the thermoforming step 5 is different from the bonding surface 3' to be surface-treated at the surface treatment step 6.

In FIG. 5, the bonding surface 3 of the first resin member 1 is thermoformed, and the bonding surface 3' of the second resin member 2 is surface-treated. However, the bonding surface 3' of the second resin member 2 may be thermoformed, and the bonding surface 3 of the first resin member 1 may be surface-treated.

### [Sixth Embodiment of Method for Producing Resin Bonded Body]

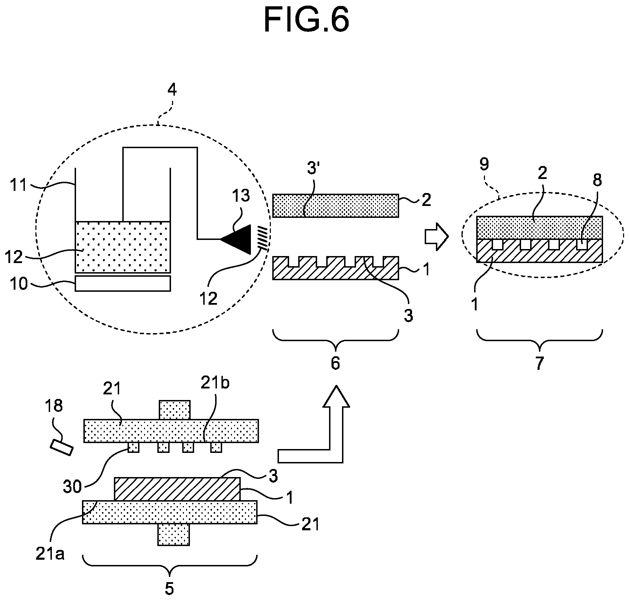

FIG. 6 is a schematic view illustrating a sixth embodiment of the method for producing the resin bonded body 9 of the present invention. In the method according to the sixth embodiment, an active liquid 12 is used for a surface treatment unit 4A at the surface treatment step 6, and the active liquid 12 is sprayed or applied by a liquid contact system 13. Thus, the active liquid 12 can be brought into contact with the bonding surface 3 of the first resin member 1 and the bonding surface 3' of the second resin member 2. The method according to the sixth embodiment is a method in which the surface treatment unit 4 at the surface treatment step 6 in the method according to the first embodiment is limited to a unit for contacting an active liquid.

The surface treatment step 6 in the methods according to the second to fifth embodiments can also be changed to the same step as the surface treatment step 6 in the method according to the sixth embodiment.

In FIG. 6, the bonding surface 3 of the first resin member 1 and the bonding surface 3' of the second resin member 2 are surface-treated. However, only any one of the bonding surface 3 and the bonding surface 3' may be surface-treated. Alternatively, the bonding surface 3' of the second resin member 2 may be thermoformed, and the bonding surface 3 of the first resin member 1 and/or the bonding surface 3' of the second resin member 2 may be surface-treated.

The "active liquid 12" in the present invention is a liquid containing one or more types of active species such as atoms and molecules (radicals) having a highly reactive unpaired electron, ions, and electrons (charged particles). The degree of activity indicating the degree of activation of the active liquid 12 can be evaluated, for example, by measurement of light-emitting intensity generated from the active species, chemical quantitative determination that measures the reaction amounts of the active species and a test liquid, electron spin resonance analysis, or the like.

The active liquid 12 is obtained by activating a liquid. Examples of the type of liquid to be activated include water, methanol, ethanol, acetic acid, and ammonia. The type of the liquid can widely be selected according to cost, safety, the dissolution resistance of the resin members 1 and 2, and the like. The liquid to be activated may be a mixed solution or an aqueous solution in which two or more types of liquids are mixed.

The active liquid 12 can be produced by activating the liquid with a liquid activation unit 10. The liquid activation unit 10 only needs to be a method for applying energy to the liquid to dissociate or ionize a molecule of the liquid, and can appropriately be selected. It is particularly preferable that the activation unit 10 is a unit for irradiating the liquid with an ionizing substance, irradiating the liquid with an electromagnetic wave, vibrating the liquid with an elastic vibration wave (sound pressure), or applying an electric field to the liquid. Among the units, any one may be used, or a plurality of the units may be used. By the units, many active species can be produced in the liquid for a short time at a high decomposition efficiency of the liquid. All of the activation units 10 are preferable since the controllability for activation of the liquid is high.

When the liquid is irradiated with an elastic vibration wave (sound pressure), air bubbles in the liquid are expanded and shrunk, resulting in breaking (cavitation). During occurrence of cavitation, the temperature of an air-liquid interface is locally increased, and the liquid is thermally decomposed to produce active species. When the amount of cavitation is changed, the degree of activity of the liquid can be controlled. The amount of cavitation can easily be controlled by the applied electric power and frequency of an oscillator generating the elastic vibration wave, the temperature of the liquid, and the like.

Examples of the method for irradiating the liquid with an ionizing substance include transporting a produced ionizing substance to the liquid using a gas stream, spraying the liquid to an ionizing substance generating part, and introducing charged particles by arranging a metal electrode plate different from a metal electrode plate for generation of an ionizing substance in the liquid and applying a direct electric current. When the liquid is irradiated with an ionizing substance, the liquid is decomposed and activated. Examples of the type of gas for production of an ionizing substance include, but not particularly limited to, argon, helium, oxygen, water vapor, and nitrogen. When the gas type, the density of an ionizing gas, and the like are changed, the type and degree of activity of active species produced in the liquid can easily be controlled. Therefore, the active liquid 12 that is appropriate can be produced according to the types of the first resin member 1 and the second resin member 2.

The "electric field" in the present invention refers to a state where a voltage is applied. When this electric field is applied to the liquid, the liquid is electrolyzed and activated. A method for generating an electric field is not particularly limited, and for example, two metal plates are inserted into the liquid, and a potential difference is applied to the metal plates to generate an electric field. When the distance between the two metal plates, the applied voltage, and the like are changed, the electric field intensity can easily be changed, and the degree of activity of the liquid can be controlled.

By any activation unit 10, the reaction rate is also increased with an increase in temperature of the liquid. Therefore, when the liquid temperature is increased, the decomposition of the liquid can be promoted. Further, when energy is applied by the activation unit 10 while the liquid is stirred with a stirrer, the active liquid 12 that is homogeneous can be produced.

The liquid contact system 13 is not particularly limited, and examples thereof include a system for conveying the active liquid 12 from a container 11 using a pump and then spraying the active liquid 12 from a spray nozzle, and a system for applying the active liquid 12 to the bonding surface 3 of the first resin member 1 and the bonding surface 3' of the second resin member 2 by an applying machine.

### [Seventh Embodiment of Method for Producing Resin Bonded Body]

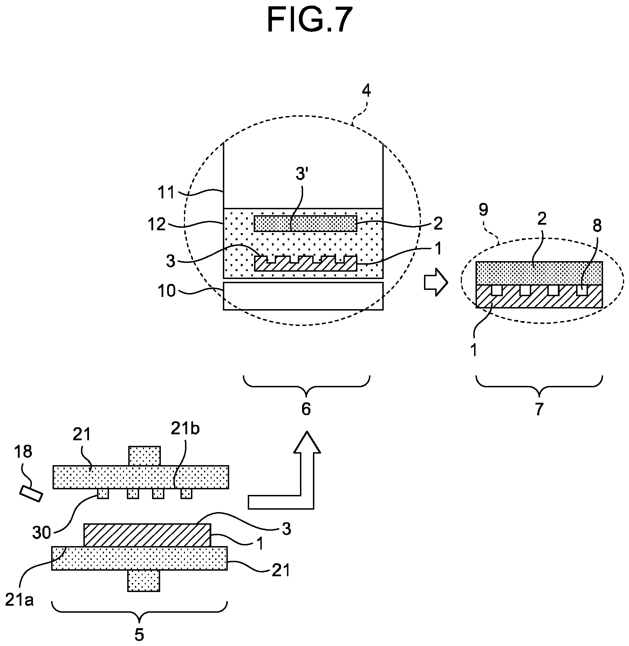

FIG. 7 is a schematic view illustrating a seventh embodiment of the method for producing a resin bonded body of the present invention. In the method according to the seventh embodiment, immersion of the first resin member 1 and the second resin member 2 in the active liquid 12 is performed as a surface treatment unit 4B. By immersion of the first resin member 1 and/or the second resin member 2 in the active liquid 12, the bonding surface 3 of the first resin member 1 and/or the bonding surface 3' of the second resin member 2 may be brought into contact with the active liquid 12. By this surface treatment method, energy is obtained from the liquid activation unit 10. Therefore, the bonding surface 3 of the first resin member 1 and the bonding surface 3' of the second resin member 2 can efficiently be activated together with a reaction with the active liquid 12. Accordingly, the bonding surface 3 of the first resin member 1 and the bonding surface 3' of the second resin member 2 can be activated for a short time. The method according to the seventh embodiment is also a method in which the surface treatment unit 4 at the surface treatment step 6 in the method according to the first embodiment is limited to a unit for contacting an active liquid.

The surface treatment step 6 in the methods according to the second to fifth embodiments can be changed to the same step as the surface treatment step 6 in the method according to the seventh embodiment.

In FIG. 7, the bonding surface 3 of the first resin member 1 and the bonding surface 3' of the second resin member 2 are surface-treated. However, only any one of the bonding surface 3 and the bonding surface 3' may be surface-treated. Alternatively, the bonding surface 3' of the second resin member 2 may be thermoformed, and the bonding surface 3 of the first resin member 1 and/or the bonding surface 3' of the second resin member 2 may be surface-treated.

### [First Embodiment of Device for Producing Resin Bonded Body]

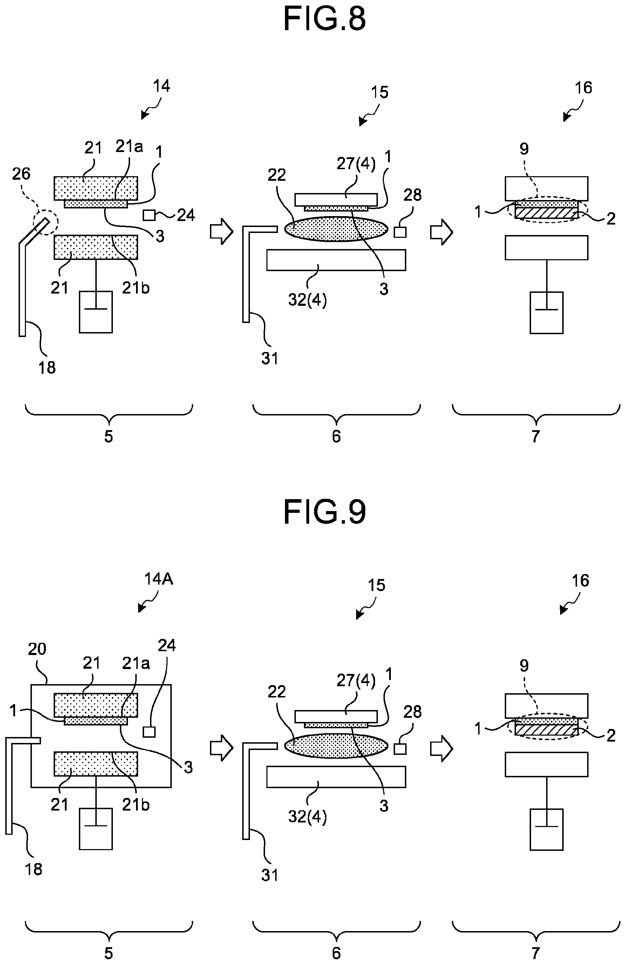

Next, a device for producing a resin bonded body of the present invention will be described. FIG. 8 is a schematic view illustrating a first embodiment of a device for producing the resin bonded body 9 of the present invention. As illustrated in FIG. 8, the device for producing the resin bonded body 9 according to the first embodiment includes a thermoforming system 14, a surface treatment system 15, and a bonding system 16. By using the device according to the first embodiment, the methods according to the first and fourth embodiments can be achieved.

### [Thermoforming System]

The thermoforming system 14 will be described. The thermoforming system 14 includes the gas supply unit 18 for supplying inert gas to the bonding surface 3 of the first resin member 1, and the molding unit 21 for molding the bonding surface 3 while the bonding surface 3 covered with the inert gas is heated. The gas supply unit 18 is not particularly limited. It is preferable that a gas nozzle or the like is used and be disposed so that a gas supply port 26 thereof faces the bonding surface 3. Thus, the bonding surface 3 can efficiently be covered with the inert gas. Alternatively, a plurality of the gas supply units 18 may be arranged. It is preferable that the thermoforming system 14 further includes an oxygen meter 24 to confirm whether the bonding surface 3 is covered with the inert gas. The molding unit 21 is not particularly limited, and examples thereof include a heat press molding machine such as a heat imprint working machine, and a laser working machine.

### [Surface Treatment System]

The surface treatment system 15 will be described. The surface treatment unit 4 of the surface treatment system 15 includes a substrate-holding system 27 and an electrode 32. It is preferable that the electrode 32 is disposed to face the bonding surface 3 of the first resin member 1 disposed on the substrate-holding system 27. Thus, it is possible to uniformly surface-treat the bonding surface 3. The surface treatment unit 4 is an ionizing substance-emitting device for emitting an ionizing substance 22. A gas supply unit 31 for supplying a gas type for producing the ionizing substance 22 is provided between the first resin member 1 and the electrode 32. When the gas type is changed according to the type of the first resin member 1, light absorption of an electromagnetic wave, and the like, the amount of a cleaved molecular chain and the type of a produced functional group can be controlled. The surface treatment unit 4 only needs to be a method for applying energy to the bonding surface 3 to cleave a molecular chain and/or a method for imparting a functional group. The surface treatment unit 4 can appropriately be changed. Instead of the ionizing substance-emitting device, an electromagnetic wave-emitting device for emitting an electromagnetic wave can also be used. When as the surface treatment unit 4, the electromagnetic wave-emitting device is used, it is preferable that the gas supply unit 31 is provided similarly to the electrolytically dissociating substance-emitting device.

Instead of the surface treatment unit 4, an active liquid contact system, for example, the surface treatment unit 4A illustrated in FIG. 6 or the surface treatment unit 4B illustrated in FIG. 7 may be used. The surface treatment unit 4A of FIG. 6 is a unit in which the liquid 12 in the container 11 is activated by the liquid activation unit 10, and the active liquid 12 is sprayed or applied by the liquid contact system 13. The surface treatment unit 4B illustrated in FIG. 7 is a unit in which the first resin member 1 and the second resin member 2 are immersed in the active liquid 12 in the container 11.

Since the ionizing substance-emitting device, the electromagnetic wave-emitting device, and the active liquid contact system can achieve a treatment at a low temperature, the amount of a cleaved molecular chain and the amount of an imparted functional group can easily be controlled without thermally deforming the concavo-convex shape of the bonding surface 3. The surface treatment system 15 may include a plurality of types of surface treatment units.

It is preferable that a process-monitoring unit 28 for monitoring a process is provided in the surface treatment system 15. When the process-monitoring unit 28 is provided, an abnormality during a surface treatment can early be found.

It is preferable that the process-monitoring unit 28 is appropriately changed according to a subject to be monitored. When the surface treatment unit 4 is the ionizing substance-emitting device, the ionizing substance-emitting device includes an emission spectrophotometer capable of measuring the light emission state of the ionizing substance. Thus, the type and degree of electrolytic dissociation of the ionizing substance can be acquired. When the surface treatment unit 4 is the electromagnetic wave-emitting device, the electromagnetic wave-emitting device includes an illuminometer, a luminance meter, or the like. Thus, the amount of light of the electromagnetic wave can be acquired. When the active liquid contact system is used, the active liquid contact system includes a pH meter, a dissolved oxygen meter, or the like. Thus, the active state of the active liquid 12 can be acquired. The gas type, the humidity, and the temperature in the surface treatment system 15 can be monitored with a mass spectrometer, a hygrometer, a thermometer, or the like.

### [Bonding System]

The bonding system 16 will be described. The bonding system 16 is a unit for attaching the bonding surface 3 of the first resin member 1 and the bonding surface 3' of the second resin member 2 to each other, and examples thereof include a thermocompression-bonding unit such as a heat press machine. A plurality of the thermocompression-bonding units may be arranged.

It is preferable that a post-heating unit for post-heating the resin bonded body 9 is disposed after the bonding system 16. Thus, the molecular diffusion and the formation of a covalent bond at the bonding interface are promoted, and the bonding force of the resin bonded body 9 can be further enhanced.

In FIG. 8, the bonding surface 3 of the first resin member 1 is thermoformed by the thermoforming system 14, and then surface-treated by the surface treatment system 15. However, the bonding surface 3' of the second resin member 2 may be thermoformed by the thermoforming system 14, and may be surface-treated by the surface treatment system 15.

### [Second Embodiment of Device for Producing Resin Bonded Body]

FIG. 9 is a schematic view illustrating a second embodiment of the device for producing the resin bonded body 9 of the present invention. A thermoforming system 14A is a difference between the device according to the first embodiment and the device according to the second embodiment. The thermoforming system 14A in the device according to the second embodiment includes the partition 20 provided so as to surround the first resin member 1, the gas supply unit 18 for supplying inert gas to the inside of the partition 20, and the molding unit 21 that is provided inside the partition 20 and molds the bonding surface 3 of the first resin member 1 under heating.

When the gas supply unit 18 for supplying inert gas to the inside of the partition 20 is provided, the bonding surface 3 can efficiently be covered with the inert gas.

By using the device according to the second embodiment, the aforementioned method according to the second embodiment can be achieved. In FIG. 9, the whole first resin member 1 is surrounded by the partition 20. However, the whole second resin member 2 may be surrounded by the partition 20. Alternatively, the whole first resin member 1 and the whole second resin member 2 may be surrounded by the partition 20, or only the bonding surface 3 of the first resin member 1 or the bonding surface 3' of the second resin member 2 may be surrounded by the partition 20.

### [Third Embodiment of Device for Producing Resin Bonded Body]

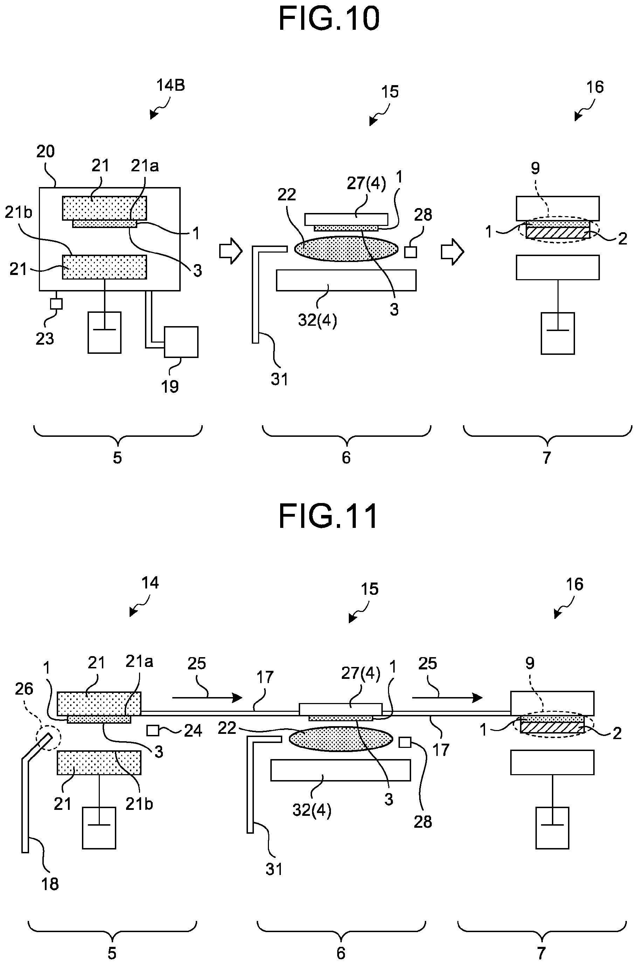

FIG. 10 is a schematic cross-sectional view illustrating a third embodiment of the device for producing a resin bonded body of the present invention. A thermoforming system 14B is a difference between the device according to the first embodiment and the device according to the third embodiment. The thermoforming system 14B in the device according to the third embodiment includes the partition 20 provided so as to surround the first resin member 1, the exhausting unit 19 for exhausting air in the inside of the partition 20 resulting in a vacuum state, and the molding unit 21 that is provided inside the partition 20 and molds the bonding surface 3 of the first resin member 1 under heating.

When air in the inside of the partition 20 is exhausted by the exhausting unit 19, the bonding surface 3 can efficiently be placed in a vacuum environment. In order to confirm the gas pressure in the partition 20, it is preferable that a vacuum gauge 23 is provided.

By using the device according to the third embodiment, the aforementioned method according to the third embodiment can be achieved. In FIG. 10, the whole first resin member 1 is surrounded by the partition 20. However, the whole second resin member 2 may be surrounded by the partition 20. Alternatively, the whole first resin member 1 and the whole second resin member 2 may be surrounded by the partition 20, or only the bonding surface 3 of the first resin member 1 or the bonding surface 3' of the second resin member 2 may be surrounded by the partition 20.

### [Fourth Embodiment of Device for Producing Resin Bonded Body]

FIG. 11 is a schematic view illustrating a fourth embodiment of the device for producing a resin bonded body of the present invention. The device according to the fourth embodiment includes a resin member-conveying system 17 for automatically conveying the first resin member 1 and the second resin member 2, in addition to the thermoforming system 14, the surface treatment system 15, and the bonding system 16. The resin member-conveying system 17 is not particularly limited, and examples thereof include a belt conveyor that conveys the first resin member 1 and the second resin member 2 with an annular belt rotated on a truck, and a conveying robot that self-travels between the steps and carries the first resin member 1 and the second resin member 2.

### [Fifth Embodiment of Device for Producing Resin Bonded Body]

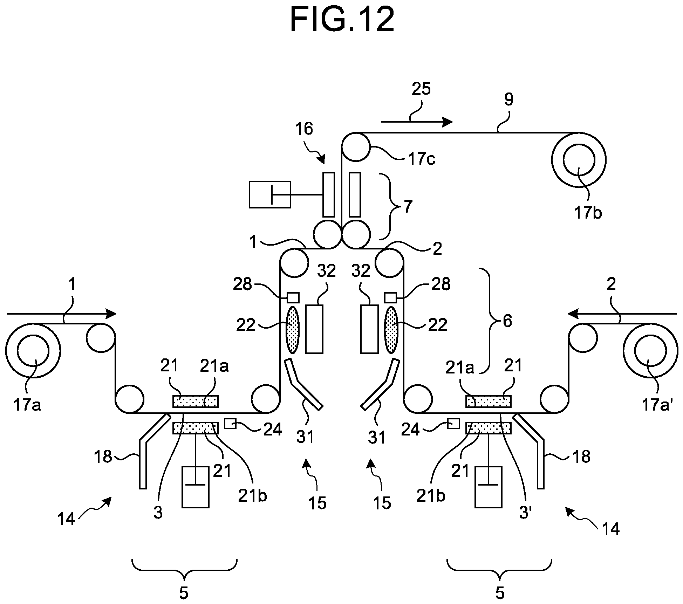

FIG. 12 is a schematic view illustrating a fifth embodiment of the device for producing a resin bonded body of the present invention. The device according to the fifth embodiment includes a resin member-conveying system including unwinding rollers 17a and 17a', a Winding roller 17b, and a conveying roller 17c, in addition to the thermoforming system 14, the surface treatment system 15, and the bonding system 16. The first resin member 1 is unrolled by the unwinding roller 17a, the second resin member 2 is unrolled by the unwinding roller 17a', the first resin member 1, the second resin member 2, and the resin bonded body 9 are conveyed by the conveying roller 17c, and the resin bonded body 9 is rolled by the winding roller 17b. When the second resin member 1 and the second resin member 2 are a thin long-length substrate, the resin bonded body 9 can continuously be produced, and productivity can be enhanced. According to the treatment times at the steps, intermittent conveyance may be performed.

### [Sixth Embodiment of Device for Producing Resin Bonded Body]

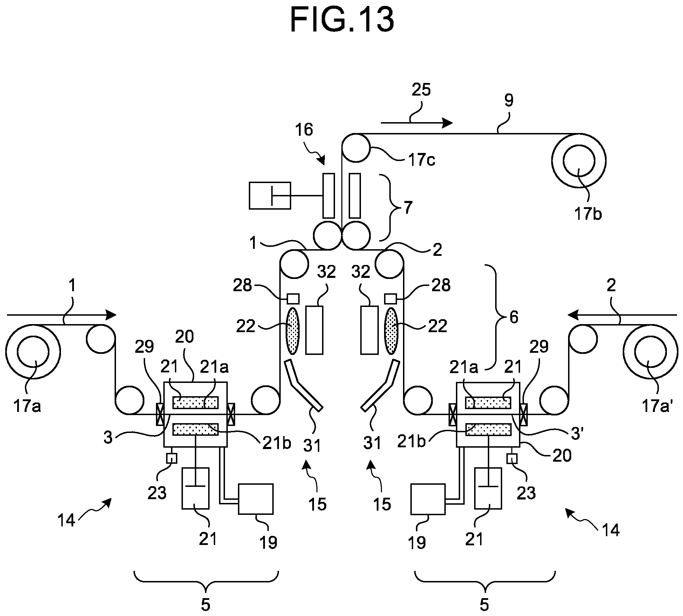

FIG. 13 is a schematic view illustrating a sixth embodiment of the device for producing a resin bonded body of the present invention. The thermoforming system 14B is a difference between the aforementioned device according to the fifth embodiment and the device according to the sixth embodiment. The thermoforming system 14B in the device according to the sixth embodiment includes the partition 20 provided so as to surround each of the bonding surface 3 of the first resin member 1 and the bonding surface 3' of the second resin member 2, the exhausting unit 19 for exhausting air in the inside of the partition 20 resulting in a vacuum state, and the molding unit 21 that is provided inside the partition 20 and molds the bonding surface 3 of the first resin member 1 and the bonding surface 3' of the second resin member 2 under heating. When the first resin member 1 and the second resin member 2 that are a thin long-length substrate are conveyed, it is preferable that a load-lock system 29 is provided at a substrate conveyance port of the partition 20 in the thermoforming system 14B. The load-lock system 29 is a system that blocks entry of air from the outside of the partition 20 to maintain the degree of vacuum in the inside of the partition 20. By the load-lock system 29, vacuum can efficiently be made inside the partition 20.

### [Seventh Embodiment of Device for Producing Resin Bonded Body]

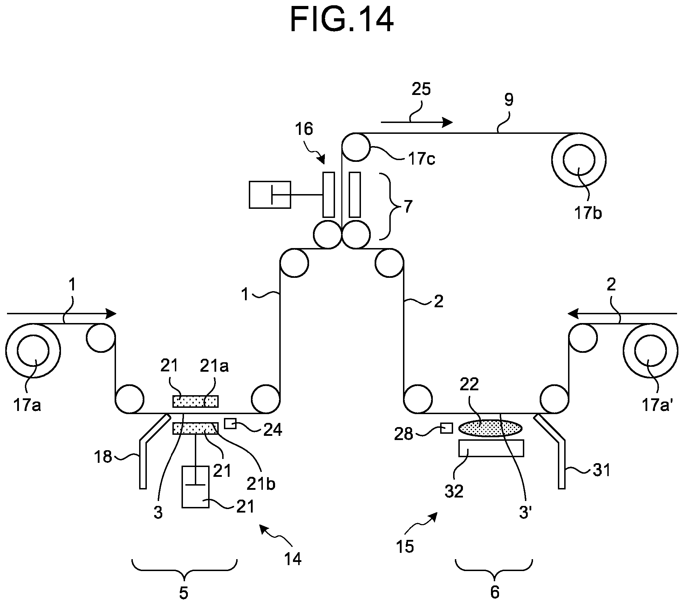

FIG. 14 is a schematic view illustrating a seventh embodiment of the device for producing a resin bonded body of the present invention. The device for producing a resin bonded body according to the seventh embodiment includes the thermoforming system 14 having the gas supply unit 18 on a conveying route of the first resin member 1, and the surface treatment system 15 on a conveying route of the second resin member 2, and the bonding system 16 is disposed on a conveying route after the thermoforming system 14 and the surface treatment system 15.

When the bonding surface 3 is thermoformed with the bonding surface 3 covered with inert gas, thermal degradation can be reduced. When the bonding surface 3' that is different from the bonding surface 3 and is not thermoformed is activated by the surface treatment system 15, the resin bonded body 9 having a high bonding force can be produced.

The device for producing a resin bonded body may include the thermoforming system 14 having the gas supply unit 18 on the conveying route of the second resin member 2, and the surface treatment system 15 on the conveying route of the first resin member 1.

### [Eighth Embodiment of Device for Producing Resin Bonded Body]

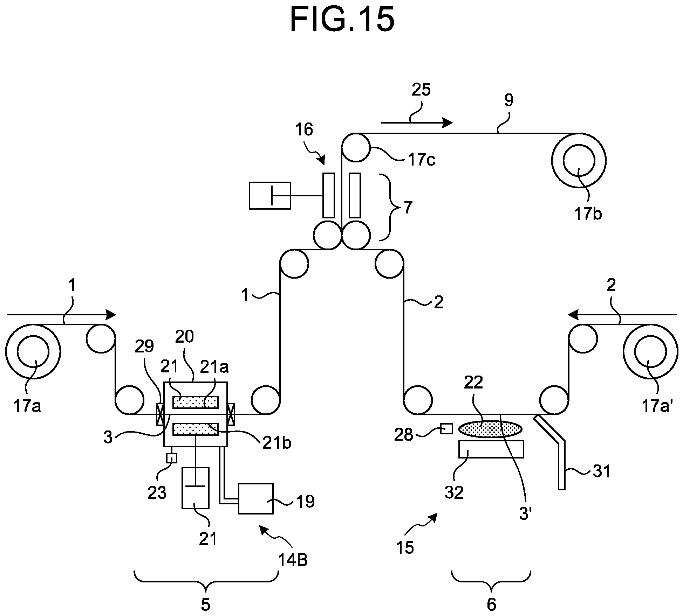

FIG. 15 is a cross-sectional view illustrating an eighth embodiment of the device for producing a resin bonded body of the present invention. In the device for producing a resin bonded body according to the eighth embodiment, the thermoforming system 14B having the partition 20 and the exhausting unit 19 is disposed on the conveying route of the first resin member 1, the surface treatment system 15 is disposed on the conveying route of the second resin member 2, and the bonding system 16 is disposed on the conveying route after the thermoforming system 14B and the surface treatment system 15.

When the bonding surface 3 is thermoformed in vacuum, thermal degradation can be reduced. When the bonding surface 3' that is different from the bonding surface 3 and is not thermoformed is activated by the surface treatment system 15, the resin bonded body 9 having a strong bonding force can be produced.

The device for producing a resin bonded body may include the thermoforming system 14B having the partition 20 and the exhausting unit 19 on the conveying route of the second resin member 2, and the surface treatment system 15 on the conveying route of the first resin member 1. Examples

In the following Examples, the method and the device for producing the resin bonded body 9 of the present invention will be described. However, the present invention is not limited to these Examples. Hereinafter, results of Examples and Comparative Examples are shown in Table 1.

### [Example 1]

By batch processing of each of the steps using the device for producing a resin bonded body according to the first embodiment illustrated in FIG. 8, the resin bonded body 9 was produced. As the first resin member 1 and the second resin member 2, a PMMA substrate (TECHNOLLOY (registered trademark) S000, glass transition temperature: 100°C) that had a thickness of 0.2 mm and was a square with a side of 50 mm was used (hereinafter, the first resin member 1 is called PMMA1, and the second resin member 2 is called PMMA2). The surface roughness (arithmetic average roughness Ra) of the PMMA substrate was confirmed with a three-dimensional microscope (OLYMPUS OLS3100), to be 10 nm.

At the thermoforming step 5, a heat press molding machine was used as the molding unit 21, and nitrogen gas was used as the inert gas. The PMMA1 was placed on the unmolded surface 21a that was a square with a side of 100 mm, and nitrogen gas was supplied at 10 L/min to the bonding surface 3 of the PMMA1 by the gas supply unit 18. The oxygen concentration at the bonding surface 3 of PMMA1 was measured with an oxygen meter (COSMOS XP-3180), to be 15%.

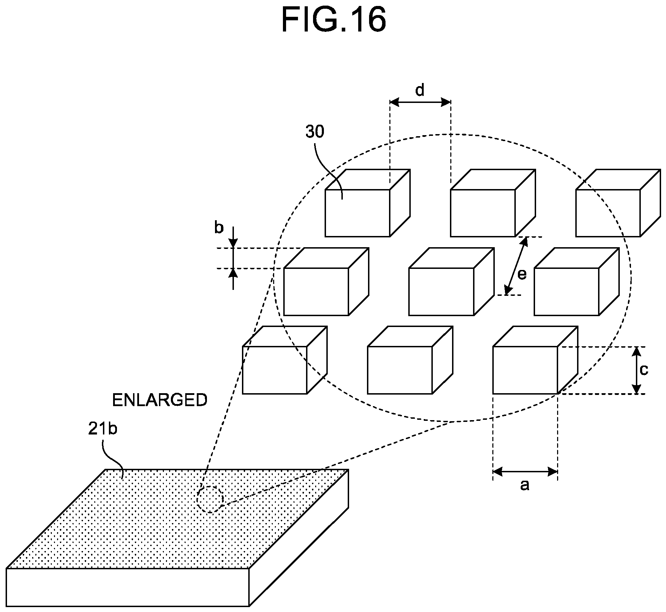

The temperatures of the unmolded surface 21a and the molding surface 21b of the heat press molding machine 21 were increased until the temperature of the bonding surface 3 was 130°C, and the bonding surface 3 was then thermoformed at a molding pressure of 6 MPa for 2 minutes. On the molding surface 21b of the heat press molding machine 21, the protrusion pattern 30 including rectangular protrusions at an interval of 50 µm (distances b and e) on a press surface that was a square with a side of 100 mm as illustrated in FIG. 16 was provided. As the size of each protrusion of the protrusion pattern 30, a protrusion width a, a protrusion length b, and a protrusion height c were 50 µm. The bonding surface 3 of PMMA1 was subjected to heat imprint molding so that the protrusion pattern 30 of the molding surface 21b was transferred.

Subsequently, at the surface treatment step 6, an ionizing gas-emitting device was used as the surface treatment system 15, the electrode 32 was disposed to face the bonding surface 3 of PMMA1 held by the substrate-holding system 27 (SUS304) at a position separated from the bonding surface 3 by 2 mm, and the bonding surface 3 of PMMA1 was surface-treated for 10 seconds. Nitrogen gas was supplied to a space between the substrate-holding system 27 (SUS304) that was at a grounding potential and was a square with a side of 100 mm, and the electrode 32 under an atmospheric pressure at 40 L/min from a gas nozzle that was the gas supply unit 18, and then a voltage (10 kV) was applied to the substrate-holding system 27 and the electrode 32 by a DC pulse power supply not shown, to produce an ionizing gas.

Next, PMMA2 was subjected to the thermoforming step 5 and the surface treatment step 6 under the same conditions as described above.

At the bonding step 7, a heat press machine was used as the bonding system 16. The press surface temperature of the heat press machine 16 was increased to adjust each substrate temperature of PMMA1 and PMMA2 to 95°C. The substrate temperatures were confirmed by an infrared thermometer (SATOTECH DT-8855). Subsequently, PMMA1 and PMMA2 were thermocompression-bonded by the heat press machine 16 for 10 minutes at 2 MPa so that the apex surface of each protrusion of the protrusion pattern 30 of the bonding surface 3 was in contact with the apex surface of each protrusion of the protrusion pattern 30 of the bonding surface 3'. As a result, PMMA1 was bonded to PMMA2.

The bonding force of a bonded sample produced as described above was evaluated by a 90° peeling test machine (SHIMADZU CORPORATION, AGS-100A). At that time, the peeling rate was set to 5 cm/min. As a result, the bonding force of the bonding sample was 0.7 N/cm.

### [Example 2]

A bonded sample of PMMA1 and PMMA2 was produced under the same conditions as in Example 1 except that the amount of nitrogen gas supplied by the gas supply unit 18 was changed to 50 L/min. The oxygen concentration at the bonding surface 3 of PMMA1 and PMMA2 was 5%.

The bonding force of the bonded sample produced as described above was 1.3 N/cm.

### [Example 3]

The device for producing a resin bonded body according to the second embodiment illustrated in FIG. 9 was used. A bonded sample of PMMA1 and PMMA2 was produced under the same conditions as in Example 1 except that at the thermoforming step 5, nitrogen gas was supplied to the inside of the partition 20 that was provided so as to surround a press surface of a square with a side of 100 mm and had an upper surface and a bottom surface having an inside size of a square with a side of 200 mm and a side surface with a height of 300 mm, from the gas supply system 18 at 10 L/min.

The bonding force of the bonded sample produced as described above was 1.3 N/cm.

### [Example 4]

The device for producing a resin bonded body according to the third embodiment illustrated in FIG. 10 was used. At the thermoforming step 5, air was exhausted under vacuum by the exhausting unit 19 so that the gas pressure in the inside of the partition 20 was 50 Pa without supplying inert gas to the inside of the partition 20 that was provided so as to surround a press surface of a square with a side of 100 mm and had an upper surface and a bottom surface having an inside size of a square with a side of 200 mm and a side surface with a height of 300 mm. Under the same conditions as in Example 1 except for the point described above, a bonded sample of PMMA1 and PMMA2 was produced. The gas pressure was measured with a vacuum gauge (ULVAC G-TRAN) installed in the partition 20.

The bonding force of the bonded sample produced as described above was 1.3 N/cm.

### [Example 5]

A bonded sample of PMMA1 and PMMA2 was produced under the same conditions as in Example 2 except that PMMA1 was thermoformed by a heat press machine as the molding unit 21, but was not surface-treated by the surface treatment system 15, and PMMA2 was not thermoformed by the molding unit 21, but was surface-treated by the surface treatment system 15.

The bonding force of the bonded sample produced as described above was 1.3 N/cm.

### [Example 6]

A bonded sample of PMMA1 and PMMA2 was produced under the same conditions as in Example 4 except that PMMA1 was thermoformed by a heat press machine as the molding unit 21, but was not surface-treated by the surface treatment system 15, and PMMA2 was not thermoformed by an ionizing gas-emitting device as the surface treatment system 21, but was surface-treated by an ionizing gas-emitting device as the surface treatment system 15.

The bonding force of the bonded sample produced as described above was 1.3 N/cm.

### [Comparative Example 1]

A bonded sample of PMMA1 and PMMA2 was produced under the same conditions as in Example 1 except that inert gas was not supplied at the thermoforming step 5.

The bonding force of the bonded sample produced as described above was 0.0 N/cm.

### [Comparison Example 2]

A bonded sample of PMMA1 and PMMA2 was produced under the same conditions as in Example 5 except that inert gas was not supplied at the thermoforming step 5.

The bonding force of the bonded sample produced as described above was 0.0 N/cm.

### [Comparison Example 3]

A bonded sample of PMMA1 and PMMA2 was produced under the same conditions as in Comparative Example 1 except that the thermoforming step 5 and the surface treatment step 6 were performed, and then the bonding step 7 with spraying ethanol between the bonding surfaces 3 and 3' of the resin members was performed.

The bonding force of the bonded sample produced as described above was 0.3 N/cm.

The results of Examples 1 to 6 and Comparative Examples 1 to 3 were summarized in Table 1. A bonding force of 1.0 N/cm or more was evaluated to be Ⓞ (very good), a bonding force of 0.5 N/cm or more and less than 1.0 N/cm was evaluated to be ○ (good), a bonding force of 0.1 N/cm or more and less than 0.5 N/cm was evaluated to be △ (slightly poor), and a bonding force of less than 0.1 N/cm was evaluated to be X (poor).

### [Table 1]

**Table 1**

| No | Resin members 1 and 2 | Thermoforming step | | | | | Surface treatment step | | Bonding step | Bonding force |
|---|---|---|---|---|---|---|---|---|---|---|
| | | Presence or absence of partition | Inert gas | Oxygen concentration | Gas pressure | Thermoforming temperature | Surface treatment unit | Solvent | Bonding temperature | |
| Example 1 | PMMA1 | Absence | N₂ (10 L/min) | 15% | 1013 hPa (atmospheric pressure) | 130°C | Treated with ionizing gas | None | 95°C | ○ 0.7N/cm |
| | PMMA2 | | | | | | | | | |
| Example 2 | PMMA1 | Absence | N₂ (50 L/min) | 5% | 1013 hPa (atmospheric pressure) | 130°C | Treated with ionizing gas | None | 95°C | Ⓞ 1.3N/cm |
| | PMMA2 | | | | | | | | | |
| Example 3 | PMMA1 | Presence | N₂ (10 L/min) | 5% | 1013 hPa (atmospheric pressure) | 130°C | Treated with ionizing gas | None | 95°C | Ⓞ 1.3N/cm |
| | PMMA2 | | | | | | | | | |
| Example 4 | PMMA1 | Presence | None | - | 50Pa (vacuum) | 130°C | Treated with ionizing gas | None | 95°C | Ⓞ 1.3N/cm |
| | PMMA2 | | | | | | | | | |
| Example 5 | PMMA1 | Absence | N₂ (50 L/min) | 5% | 1013hPa (atmospheric pressure) | 130°C | Not treated | | 95°C | Ⓞ 1.3N/cm |
| | PMMA2 | Not treated | | | | | Treated with ionizinq qas | None | | |
| Example 6 | PMMA1 | Presence | None | - | 50Pa (vacuum) | 130°C | Not treated | | 95°C | Ⓞ 1.3N/cm |
| | PMMA2 | Not treated | | | | | Treated with ionizing qas | None | | |
| Comparative Example 1 | PMMA1 | Absence | None | 20% | 1013hPa (atmospheric pressure) | 130°C | Treated with ionizing gas | None | 95°C | × 0.0N/cm |
| | PMMA2 | | | | | | | | | |
| Comparative Example 2 | PMMA1 | Absence | None | 20% | 1013hPa (atmospheric pressure) | 130°C | Not treated | | 95°C | × 0.0N/cm |
| | PMMA2 | Not treated | | | | | Treated with ionizinq qas | None | | |
| Comparative Example 3 | PMMA1 | Absence | None | 20% | 1013hPa (atmospheric pressure) | 130°C | Treated with ionizing gas | Presence | 95°C | △ 0.3N/cm |
| | PMMA2 | | | | | | | | | |

### Industrial Applicability

Using the method for producing a resin bonded body of the present invention, an adhesive-free resin bonded body having a high bonding force can easily be obtained while the resin bonded body requires a thermoforming step. For example, the method can be applied to a packaging material and an optical film, but a range of the application is not limited to them.

### Reference Signs List

- 1: First resin member
- 2: Second resin member
- 3, 3': Bonding surface
- 4, 4A, 4B: Surface treatment unit
- 5: Thermoforming step
- 6: Surface treatment step
- 7: Bonding step
- 8: Hollow structure
- 9: Resin bonded body
- 10: Liquid activation unit
- 11: Container
- 12: Active liquid
- 13: Liquid contact system
- 14, 14A, 14B: Thermoforming system
- 15: Surface treatment system
- 16: Bonding system
- 17: Conveyance system
- 17a, 17a': Unwinding roller
- 17b: Winding roller
- 17c: Conveyance roller
- 18, 31: Gas supply unit
- 19: Exhausting unit
- 20: Partition
- 21: Molding unit
- 21a: Unmolded surface
- 21b: Molding surface
- 22: Activated liquid
- 23: Vacuum gauge
- 24: Oxygen meter
- 25: Conveyance direction
- 26: Gas supply port
- 27: Substrate-holding system
- 28: Process-monitoring unit
- 29: Load-lock system
- 30: Protrusion pattern
- 32: Electrode

## Claims

1. A method for producing a resin bonded body including a first resin member and a second resin member that are bonded to each other, the method comprising:
a thermoforming step of thermoforming a bonding surface of the first resin member to be bonded to the second resin member and/or a bonding surface of the second resin member to be bonded to the first resin member with the bonding surface covered with inert gas or placed in a vacuum environment;
a surface treatment step of activating the bonding surface of the first resin member and/or the bonding surface of the second resin member; and
a bonding step of attaching the first resin member and the second resin member to each other through the bonding surface of each of the first resin member and the second resin member after the thermoforming step and the surface treatment step.

2. The method for producing a resin bonded body according to claim 1, wherein
the thermoforming step is a step of thermoforming any one of the bonding surface of the first resin member to be bonded to the second resin member and the bonding surface of the second resin member to be bonded to the first resin member, and
the surface treatment step is a step of activating the bonding surface of the resin member that is not thermoformed at the thermoforming step.

3. The method for producing a resin bonded body according to claim 1 or 2, wherein a unit that performs the surface treatment at the surface treatment step is at least one selected from the group consisting of irradiating the bonding surface of the first resin member and/or the second resin member with an ionizing substance, irradiating the bonding surface of the first resin member and/or the second resin member with an electromagnetic wave, and contacting the bonding surface of the first resin member and/or the second resin member with an active liquid.

4. A device for producing a resin bonded body including a first resin member and a second resin member that are bonded to each other, used in production of the resin bonded body, the device comprising:
a thermoforming system;
a surface treatment system; and
a bonding system, wherein
the thermoforming system includes
a gas supply unit configured to supply inert gas to a bonding surface of the first resin member to be bonded to the second resin member and/or a bonding surface of the second resin member to be bonded to the first resin member such that the bonding surface of the first resin member and/or the bonding surface of the second resin member is covered with the inert gas, and
a molding unit configured to mold the bonding surface of the first resin member and/or the second resin member that is covered with the inert gas under heating,
the surface treatment system is configured to activate the bonding surface of the first resin member and/or the bonding surface of the second resin member, and
the bonding system is configured to attach the first resin member and the second resin member to each other through the bonding surface of each of the first resin member and the second resin member.

5. A device for producing a resin bonded body including a first resin member and a second resin member that are bonded to each other, used in production of the resin bonded body, the device comprising:
a thermoforming system;
a surface treatment system; and
a bonding system, wherein
the thermoforming system includes
a partition provided so as to surround a bonding surface of the first resin member to be bonded to the second resin member and/or a bonding surface of the second resin member to be bonded to the first resin member,
a gas supply unit configured to supply inert gas into the partition or an exhausting unit configured to exhaust air in inside of the partition resulting in a vacuum state, and
a molding unit that is provided inside the partition, the molding unit being configured to mold the bonding surface of the first resin member and/or the second resin member under heating,
the surface treatment system is configured to active the bonding surface of the first resin member and/or the second resin member, and
the bonding system is configured to attach the first resin member and the second resin member to each other through the bonding surface of each of the first resin member and the second resin member.
